# EUROPEAN PATENT APPLICATION

(11) **EP 1 775 262 A1**
(43) Date of publication of application: **18.04.2007**
(21) Application number: 05736751.8
(22) Date of filing: 28.04.2005
(51) Int. Cl.: C01B 31/02, G02B 5/18, C23C 14/06, C23C 16/26

(54) **HYDROGEN-CONTAINING CARBON FILM**

(30) Priority: 29.07.2004 JP 2004221946
(71) Applicant: Sumitomo Electric Industries, Ltd., Osaka-shi, Osaka 541-0041 (JP)
(72) Inventor: ODA, Kazuhiko c/o Itami Works of Sumitomo Electric, Hyogo (JP); MATSUURA, Takashi c/o Itami Works of Sumitomo, Itami-shi Hyogo (JP); USHIRO, Toshihiko c/o Itami Works of Sumitomo, Itami-shi Hyogo (JP)
(74) Representative: HOFFMANN EITLE
(86) International application number: PCT/JP2005/008111
(87) International publication number: WO 2006/011279

(57) **Abstract**

To provide a hydrogen-containing carbonaceous membrane having a novel property. For example, the hydrogen-containing carbonaceous membrane may be effectively prevented from delamination from a substrate.

A hydrogen-containing carbonaceous membrane includes carbon and hydrogen. The membrane has a hydrogen content of more than 50 atomic percent and less than 65 atomic percent and a density of more than 1.3 g/cm³ and less than 1.5 g/cm³. Another hydrogen-containing carbonaceous membrane has a hydrogen content of more than 0 atomic percent and less than 50 atomic percent and a density of more than 1.4 g/cm³ and less than 1.9 g/cm³.

## Description

### Technical Field

The present invention relates to hydrogen-containing carbonaceous membranes. More specifically, it relates to hydrogen-containing carbonaceous membranes having novel properties. For example, such hydrogen-containing carbonaceous membranes are effectively prevented from delamination from substrates on which they are arranged.

### Background Art

Hydrogen-containing carbonaceous membranes containing carbon and hydrogen have good mechanical properties and chemical stability and have therefore been mainly used as coating materials for tools, molds, mechanical parts, electric parts, and optical parts. The applications of hydrogen-containing carbonaceous membranes have become wider and wider. Hydrogen-containing carbonaceous membranes having a variety of properties have been developed according to the applications.

Patent Document 1, for example, discloses a tape deck bearing a hydrogen-containing carbonaceous membrane as the outermost surface of a capstan shaft, which hydrogen-containing carbonaceous membrane has a Knoop hardness of 5000 kg/mm², a density of 2.49, and a hydrogen content of 25% (refer to Paragraph [0039] and Table 1 in Patent Document 1). This hydrogen-containing carbonaceous membrane, however, shows decreased adhesion and delaminates on the way of aging, if the membrane has an increased thickness of, for example, 0.5 µm (refer to Paragraphs [0064] and [0066] in Patent Document 1).

Patent Document 2 discloses a magnetic recording medium having a magnetic layer and a hydrogen-containing carbonaceous membrane arranged as a protecting layer on the magnetic layer. The hydrogen-containing carbonaceous membrane has a density of 2.5 g/cm³, a hardness of about 50 GPa, and a hydrogen content of about 8 to 18 atomic percent (refer to Claims 13, 14, and 16 of Patent Document 2). The hydrogen-containing carbonaceous membrane may not have an increased thickness larger than 15 nm, because the membrane has an increasing surface roughness with an increasing thickness (refer to lines 9 and 10, page 16 of Patent Document 2).

Patent Document 3 discloses a hydrogen-containing carbonaceous membrane having a density of 2.8 g/cm³ or more and 3.3 g/cm³ or less, a spin density of 1x 10¹⁸ spins/cm³ or more and 1x 10²¹ spins/cm³ or less, a carbon content of 99.5 atomic percent or more, a hydrogen content of 0.5 atomic percent or less, and a Knoop hardness of 2000 or more and 6000 or less (refer to claims of Patent Document 3). This hydrogen-containing carbonaceous membrane, however, has a high density and a high hardness and is thereby susceptible to delamination from a substrate when it has an increased thickness, as with the hydrogen-containing carbonaceous membrane disclosed in Patent Document 1.
Patent Document 1: Japanese Unexamined Patent Application Publication No. 7-121938
Patent Document 2: PCT Japanese Translation Patent Publication No. 2000-512053
Patent Document 3: Japanese Unexamined Patent Application Publication No. 2003-147508

### Disclosure of Invention

### Problems to be Solved by the Invention

An object of the present invention is to provide a hydrogen-containing carbonaceous membrane having a novel property such as effective prevention of the hydrogen-containing carbonaceous membrane from delamination from a substrate.

### Means to Solve the Problems

The present invention provides, according to a first embodiment, a hydrogen-containing carbonaceous membrane which contains carbon and hydrogen, which hydrogen-containing carbonaceous membrane has a hydrogen content of more than 50 atomic percent and less than 65 atomic percent and has a density of more than 1.3 g/cm³ and less than 1.5 g/cm³.

Hydrogen-containing carbonaceous membranes according to the first embodiment of the present invention may have a compressive stress. The compressive stress is preferably more than 0.01 gigapascals (GPa) and less than 1 GPa.

Hydrogen-containing carbonaceous membranes according to the first embodiment of the present invention preferably has a spin density of less than 5x 10¹⁶ spins/cm³.

The present invention further provides, according to a second embodiment, a hydrogen-containing carbonaceous membrane containing carbon and hydrogen, which hydrogen-containing carbonaceous membrane has a hydrogen content of more than 0 atomic percent and less than 50 atomic percent and has a density of more than 1.4 g/cm³ and less than 1.9 g/cm³.

The hydrogen-containing carbonaceous membrane according to the second embodiment of the present invention may have a tensile stress. The tensile stress is preferably more than 0.05 GPa and less than 1 GPa.

The hydrogen-containing carbonaceous membrane according to the second embodiment of the present invention preferably has a spin density of more than 1x 10¹⁷ spins per cubic centimeter (spins/cm³) and less than 1x 10²⁰ spins/cm³.

The present invention further provides, according to a third embodiment, a hydrogen-containing carbonaceous membrane containing carbon and hydrogen, which hydrogen-containing carbonaceous membrane includes at least one region and another region, the one region having a hydrogen content of more than 50 atomic percent, and the other region having a hydrogen content of less than 50 atomic percent.

In the hydrogen-containing carbonaceous membrane according to the third embodiment of the present invention, the region having a hydrogen content of more than 50 atomic percent may include hydrogen-containing carbonaceous membranes according to the first embodiment, and the region having a hydrogen content of less than 50 atomic percent may include hydrogen-containing carbonaceous membrane according to the second embodiment.

In the hydrogen-containing carbonaceous membrane according to the third embodiment of the present invention, the region having a hydrogen content of more than 50 atomic percent may be a region having a relatively low refractive index, and the region having a hydrogen content of less than 50 atomic percent may be a region having a relatively high refractive index.

In the hydrogen-containing carbonaceous membrane according to the third embodiment of the present invention, the region having a hydrogen content of more than 50 atomic percent may be a region having a relatively high electric resistivity, and the region having a hydrogen content of less than 50 atomic percent may be a region having a relatively low electric resistivity.

The hydrogen-containing carbonaceous membranes according to the second and third embodiments of the present invention may have a distribution of hydrogen content in a thickness direction.

### Advantageous Effect of the Invention

The present invention provides hydrogen-containing carbonaceous membranes having novel properties. For example, they are effectively prevented from delamination from substrates on which they are arranged.

### Brief Description of the Drawings

Figure 1 is a schematic enlarged top view of a preferred embodiment of hydrogen-containing carbonaceous membranes according to the third embodiment of the present invention.
Figure 2 is a schematic cross-sectional view of a preferred embodiment of a refractive index-modulated diffractive optical element using the hydrogen-containing carbonaceous membrane according to the third embodiment of the present invention.
Figure 3 is a schematic cross-sectional view illustrating a preferred embodiment of diverging actions of the diffractive optical element in Fig. 2 when used as a wavelength diplexer.
Figure 4 is a schematic cross-sectional view illustrating a preferred embodiment of power diverging actions of the diffractive optical element in Fig. 2 when used as a photocoupler.
Figure 5 is a schematic cross-sectional view illustrating a preferred embodiment of polarized light diverging actions of the diffractive optical element in Fig. 2 when used as a polarized light diplexer.
Figure 6 is a schematic cross-sectional view illustrating a preferred embodiment of part of fabrication processes of the diffractive optical element in Fig. 2.

### Explanation of Referenced Numerals

1, 2, 4, and 5: region, 3: substrate, 6: hydrogen-containing carbonaceous membrane, 7: gold mask, 8: helium ion.

### Best Mode for Carrying Out the Invention

Embodiments of the present invention will be illustrated below. In the attached drawings of the present application, identical reference numerals indicate identical or corresponding portions, respectively.

Hydrogen-containing carbonaceous membranes according to the first embodiment of the present invention are each a hydrogen-containing carbonaceous membrane comprising carbon and hydrogen. The hydrogen-containing carbonaceous membranes have a hydrogen content of more than 50 atomic percent and less than 65 atomic percent and have a density of more than 1.3 g/cm³ and less than 1.5 g/cm³. These hydrogen-containing carbonaceous membranes have such specific hydrogen contents and densities and are thereby flexible. Consequently, the hydrogen-containing carbonaceous membranes are effectively prevented from delamination from substrates, even when the hydrogen-containing carbonaceous membranes are each arranged in a large thickness on a flexible substrate. This is because the hydrogen-containing carbonaceous membranes capable of responding to a change, for example, in curvature of the substrate. The hydrogen-containing carbonaceous membranes having the specific hydrogen contents and the specific densities can have a large thickness without increasing their surface roughness. In contrast to this, hydrogen-containing carbonaceous membranes having smaller hydrogen contents and higher densities may delaminate from substrates and thereby may not have a sufficiently large thickness. Alternatively, they may have an increasing surface roughness with an increasing thickness.

The hydrogen contents of hydrogen-containing carbonaceous membranes can be determined by calculation typically according to Rutherford backscattering spectrometry (RBS) and hydrogen forward scattering spectrometry (HFS). According to this technique, for example, helium ions are applied to a sample hydrogen-containing carbonaceous membrane, a detector detects helium ions scattered backward and also detects hydrogens in the hydrogen-containing carbonaceous membrane scattered forward. The composition of constitutional elements including the hydrogen content is then determined by calculation. The densities of hydrogen-containing carbonaceous membranes may be determined by calculation typically according to a grazing incidence X-ray reflectivity (GIXR) technique. According to this technique, the density of a hydrogen-containing carbonaceous membrane is determined by calculation based typically on the reflectivity of X-rays applied to the hydrogen-containing carbonaceous membrane.

The hydrogen-containing carbonaceous membranes according to the first embodiment of the present invention may have a compressive stress. The compressive stress is preferably more than 0.01 GPa and less than 1 GPa. When the hydrogen-containing carbonaceous membranes have a compressive stress within the above-specified range, they may become further resistant to delamination from substrates even with increasing thicknesses of the hydrogen-containing carbonaceous membranes. The compressive stress herein may be determined by calculation typically from the curvature and thickness of the substrate after arranging the hydrogen-containing carbonaceous membrane on the substrate.

The spin density is preferably less than 5x 10¹⁶ spins/cm³ in the hydrogen-containing carbonaceous membranes according to the first embodiment of the present invention. By satisfying this, the hydrogen-containing carbonaceous membranes may have a decreased defect density. Accordingly, the hydrogen-containing carbonaceous membranes have tendencies to have an improved insulation property and a decreased light absorption. The spin density herein is determined by calculation according to an electron spin resonance (ESR) technique. A "spin density" is synonymous with an unpaired electron density. A higher spin density indicates a larger amount of dangling bonds, namely a larger amount of defects, in a hydrogen-containing carbonaceous membrane.

The hydrogen-containing carbonaceous membranes according to the first embodiment of the present invention can have a hardness of more than 30 and less than 200 in terms of Knoop hardness. They may have an electric resistivity of 1x 10⁹ Ωcm or more. They can have an extinction coefficient of less than 2x 10⁻⁴ with respect to visible radiations (green) and an extinction coefficient of less than 1x 10⁻⁴ with respect to radiation at a wavelength of 1550 nm. They can also have a refractive index with respect to visible radiation to infrared rays of 1.48 to 1.6. The Knoop hardness herein may be determined by calculation according to a known procedure for measuring Knoop hardness. The electric resistivity may be determined by calculation typically according to a four probe technique. The extinction coefficient and the refractive index may be determined by calculation typically according to ellipsometry or spectroscopic ellipsometry, or by using a spectroscope.

The hydrogen-containing carbonaceous membranes according to the first embodiment of the present invention may be used, for example, as or in interlayer dielectric films, dielectric films arranged on conductors, films or membranes having a distribution of electric resistivity, antistatic materials, membranes or films having a distribution of refractive index, diffractive optical elements (DOEs), waveguides, membranes or films having a distribution of transmittance, antireflection coating materials, and optical recording materials.

The hydrogen-containing carbonaceous membranes according to the first embodiment of the present invention may be prepared, for example, according to a radiofrequency plasma chemical vapor deposition (RF plasma CVD) technique. Raw materials for use in the technique can be, for example, at least one hydrocarbon gas selected from the group consisting of methane (CH₄), propane (C₃H₈), butane (C₄H₁₀), hexane (C₆H₁₄), octane (C₈H₁₈), acetylene (C₂H₂), benzene (C₆H₆), and cyclohexane (C₆H₁₂). Among them, preferred are hydrocarbon gases having a molecular weight equal to or higher than that of propane. This is because these gases may form films at relatively high speed with relatively less electric power, and the resulting hydrogen-containing carbonaceous membrane may have high optical transparency. According to this technique, a hydrogen-containing carbonaceous membrane can be prepared by placing a substrate at a temperature of room temperature to 150°C on a RF electrode in a RF plasma CVD system, applying RF electric power to the substrate while feeding any of the hydrogen gases to the RF plasma CVD system. Conditions in this procedure may be appropriately adjusted so as to allow the resulting hydrogen-containing carbonaceous membrane formed on the substrate to have the above-specified properties such as hydrogen content and density. Such conditions include electric power applied to the substrate, composition and amount of the hydrocarbon gas. The substrate may be, for example, a substrate comprising quartz, silicone, a polyimide resin bearing copper interconnections, or an epoxy resin bearing copper interconnections. The fabrication of hydrogen-containing carbonaceous membranes has been described above by taking a RF plasma CVD technique as an example of the fabrication process. The fabrication can also be carried out, for example, using a cathode arc ion plating technique or a sputtering technique, instead of a RF plasma CVD technique.

Hydrogen-containing carbonaceous membranes according to the second embodiment of the present invention are each a hydrogen-containing carbonaceous membrane comprising carbon and hydrogen, which has a hydrogen content of more than 0 atomic percent and less than 50 atomic percent and has a density of more than 1.4 g/cm³ and less than 1.9 g/cm³. Flexible hydrogen-containing carbonaceous membranes can also be obtained by specifying the hydrogen content and density of hydrogen-containing carbonaceous membranes. Accordingly, the resulting hydrogen-containing carbonaceous membranes may be effectively prevented from delamination from substrates. These hydrogen- containing carbonaceous membranes can also be arranged in a large thickness on a substrate. The hydrogen contents of hydrogen-containing carbonaceous membranes can be determined by calculation typically according to Rutherford backscattering spectrometry (RBS) and hydrogen forward scattering spectrometry (HFS), and the densities thereof can be determined by calculation typically according to an X-ray reflectivity (GIXR) technique, as above.

The hydrogen-containing carbonaceous membranes according to the second embodiment of the present invention may have a tensile stress. The tensile stress is preferably more than 0.05 GPa and less than 1 GPa. This tends to enable the hydrogen-containing carbonaceous membranes arranged on substrates to be resistant to changes with time. The hydrogen-containing carbonaceous membranes tend to have a tensile stress. In contrast, membranes prepared by vapor phase growth generally have a compressive stress. The tensile stress herein may be determined by calculation by the procedure of determining the compressive stress in the hydrogen-containing carbonaceous membranes according to the first embodiment.

The hydrogen-containing carbonaceous membranes according to the second embodiment of the present invention preferably have a spin density of more than 1x 10¹⁷ spins/cm³ and less than 1x 10²⁰ spins/cm³. By satisfying this, the hydrogen-containing carbonaceous membranes tend to have a decreased electric resistivity and an increased optical absorption. The spin density herein may be determined by calculation according to an electron spin resonance (ESR) technique, as in the hydrogen-containing carbonaceous membranes according to the first embodiment.

The hydrogen-containing carbonaceous membranes according to the second embodiment of the present invention can have a hardness in terms of Knoop hardness of more than 40 and less than 800. They may have an electric resistivity of 1 to 1x 10⁹ Ωcm. They may have an extinction coefficient of 5x 10⁻⁴ to 5x 10⁻² with respect to visible radiations (green) and an extinction coefficient of 3x 10⁻⁴ to 3x 10⁻² with respect to radiation at a wavelength of 1550 nm. They may have a refractive index of 1.55 to 2.4 with respect to visible radiations or infrared rays. The Knoop hardness, electric resistivity, extinction coefficient, and refractive index herein may be determined by calculation by the same procedures as in the hydrogen-containing carbonaceous membranes according to the first embodiment. The hydrogen-containing carbonaceous membranes according to the second embodiment of the present invention may be used in similar applications to those in the hydrogen-containing carbonaceous membranes according to the first embodiment.

The hydrogen-containing carbonaceous membranes according to the second embodiment of the present invention may be prepared, for example, by applying ions, radiations, or electron beams to the hydrogen-containing carbonaceous membranes according to the first embodiment.

Ions to be applied may be ions of, for example, hydrogen, helium, boron, carbon, and nitrogen. Among them, ions of hydrogen or helium are preferred, because they can penetrate hydrogen-containing carbonaceous membranes deep. Ions may be accelerated at energy of, for example, 50 keV to 8 MeV. The acceleration energy is preferably 100 keV to 400 keV at which ions can penetrate the membranes deep at industrially low cost. The amount of ions to be injected is, for example, 1x 10¹⁶ to 5x 10¹⁷ ion per square centimeter (ions/cm²) and preferably 7x 10¹⁵ to 2x 10¹⁷ ions/cm².

Radiations to be applied include, for example, ultraviolet (UV) laser light such as krypton fluoride (KrF) laser light at a wavelength of 248 nm, xenon chloride (XeCl) laser light at a wavelength of 308 nm, and argon fluoride (ArF) laser light at a wavelength of 193 nm; radiations from UV lamps, such as radiations from lamps at wavelengths of 200 to 300 nm; synchrotron radiation (SR) light such as continuous light at 50 to 2000 electron volts (eV); and gamma rays. The application of UV laser light herein may be carried out by applying UV laser light at an average power of 1 to 100 W/cm² for 5 to 240 minutes. The irradiation of UV lamp radiation may be carried out by applying radiation from an UV lamp at 5 to 200 W/cm² for 0.5 to 120 hours. The synchrotron radiation can be applied at an irradiation of, for example, 10 to 500 mA.min/mm².

The application of electron beams may be carried out by applying electron beams with energy of 1 to 80 keV, preferably with energy of 5 to 20 keV at an irradiation of 0.1 microcoulombs per square centimeter (µC/cm²) to 10 millicoulombs per square centimeter (mC/cm²), and preferably at an irradiation of 1 µC/cm² to 1 mC/cm².

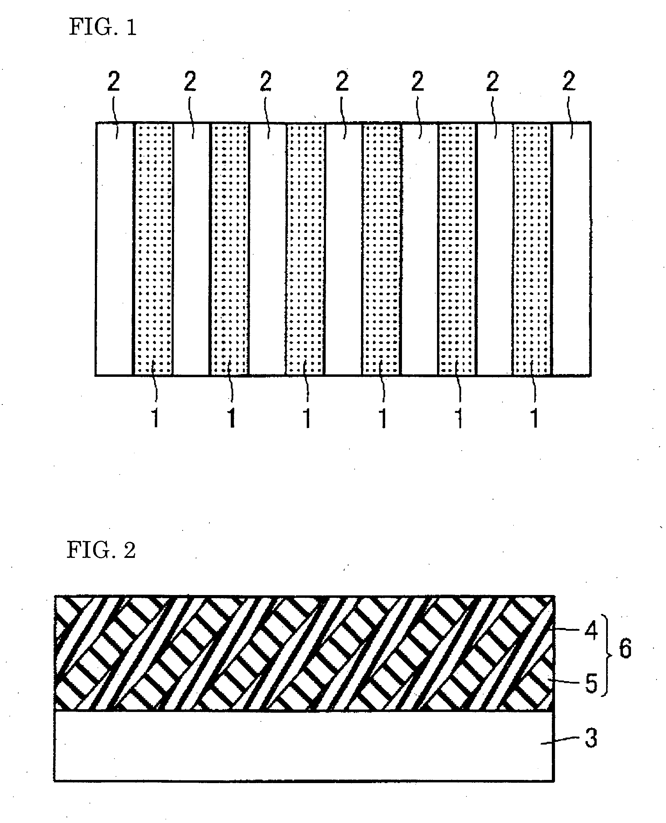

Figure 1 is an enlarged top view illustrating a preferred embodiment of hydrogen-containing carbonaceous membranes according to the third embodiment of the present invention. This hydrogen-containing carbonaceous membrane is a hydrogen-containing carbonaceous membrane comprising carbon and hydrogen. It has regions 1 each having a hydrogen content of more than 50 atomic percent and regions 2 each having a hydrogen content of less than 50 atomic percent. The stress in an entire hydrogen-containing carbonaceous membrane may be reduced by allowing the hydrogen-containing carbonaceous membrane to have a region 1 having a hydrogen content of more than 50 atomic percent and a region 2 having a hydrogen content of less than 50 atomic percent. This is because the resulting hydrogen-containing carbonaceous membrane has both a compressive stress and a tensile stress. Consequently, the hydrogen-containing carbonaceous membrane may be effectively prevented from delamination from a substrate even when the membrane is arranged in a large thickness on the substrate. When hydrogen-containing carbonaceous membranes have a distribution of hydrogen content in a direction in parallel with their surface, the resulting elements may be useful chemically, acoustically, electrically, or optically. Such hydrogen-containing carbonaceous membranes include, for example, a hydrogen-containing carbonaceous membrane comprising the hydrogen-containing carbonaceous membrane according to the first embodiment and the hydrogen-containing carbonaceous membrane according to the second embodiment as the region 1 having a hydrogen content of more than 50 atomic percent and the region 2 having a hydrogen content of less than 50 atomic percent, respectively.

A region having a relatively low refractive index and another region having a relatively high refractive index may constitute the region having a hydrogen content of more than 50 atomic percent and the region having a hydrogen content of less than 50 atomic percent, respectively, in the hydrogen-containing carbonaceous membranes according to the third embodiment of the present invention. Optically useful elements may be obtained by allowing hydrogen-containing carbonaceous membranes to have a distribution of refractive index in a direction in parallel with their surface.

These hydrogen-containing carbonaceous membranes having a distribution of refractive index in a direction in parallel with the surface may be used as, for example, refractive index-modulated diffractive optical elements. Fig. 2 is a schematic cross-sectional view showing a preferred embodiment of refractive index-modulated diffractive optical elements using the hydrogen-containing carbonaceous membranes. This diffractive optical element includes a translucent substrate 3 and a hydrogen-containing carbonaceous membrane 6 arranged on the substrate 3. The hydrogen-containing carbonaceous membrane 6 includes regions 4 each having a relatively low refractive index and regions 5 each having a relatively high refractive index.

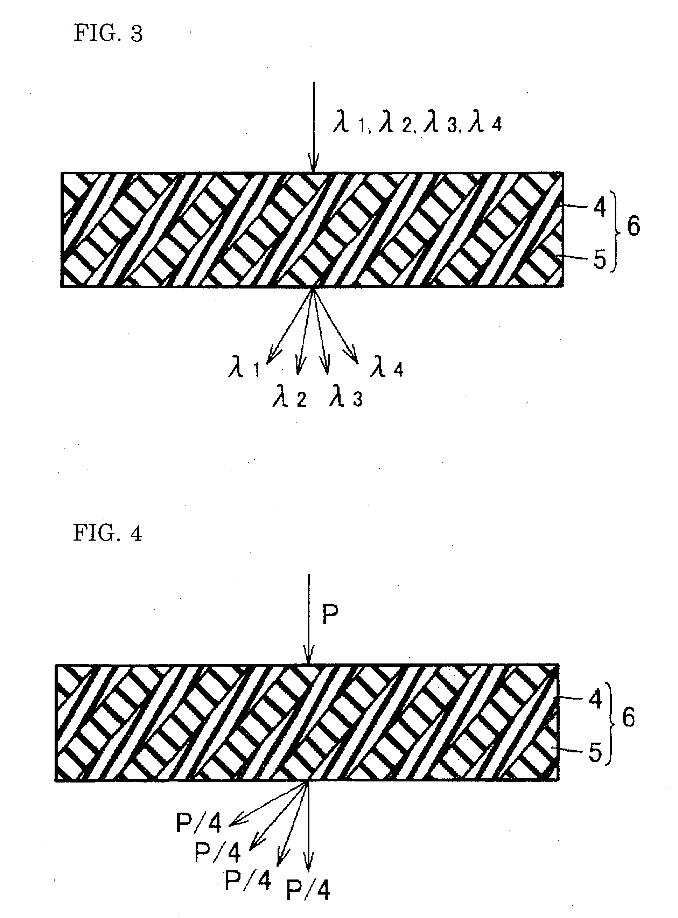

Figure 3 is a schematic cross-sectional view illustrating a preferred embodiment of diverging actions of the diffractive optical element in Fig. 2 when used as a wavelength diplexer. With reference to Fig. 3, when a single incoming beam having wavelengths λ1, *λ*2*, λ*3*,* λ4, for example, comes into the diffractive optical element, the incoming beam passing through the diffractive optical element diffracts at different angles depending on the wavelengths. As a result, the single incoming beam separates into plural diffraction beams traveling in different directions depending on the wavelengths. The diffractive optical element shown in Fig. 3 can be used as a multiplexer. In this case, the incoming beam and diffracted rays have reversed directions to those in Fig. 3.

Figure 4 is a schematic cross-sectional view illustrating a preferred embodiment of power diverging actions of the diffractive optical element in Fig. 2 when used as a photocoupler (a power diverging device). When an incoming beam having a single wavelength with power P comes into the diffractive optical element, the incoming beam passing through the diffractive optical element diffracts at different angles depending on orders of diffraction. Consequently, the incoming beam with a single wavelength can separate into plural diffracted rays having power of P/4, respectively.

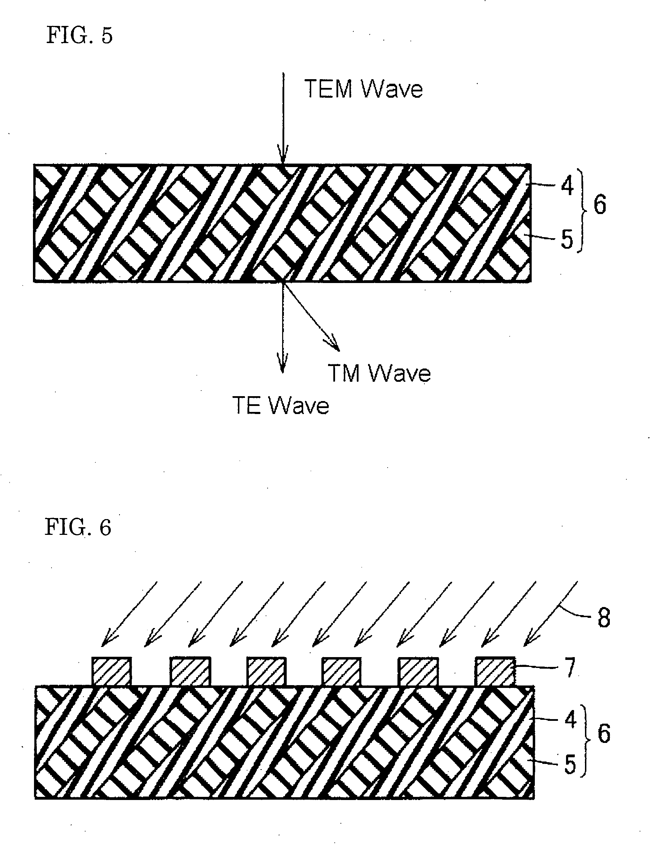

Figure 5 is a schematic cross-sectional view illustrating a preferred embodiment of polarized light diverging actions of the diffractive optical element in Fig. 2 when used as a polarized light diplexer. Specifically, when a transverse electromagnetic wave (TEM wave) including a transverse electric (TE) component and a transverse magnetic (TM) component comes into the diffractive optical element, a TE wave and a TM wave diffract at different diffraction angles depending on difference in their polarization light. Thus, the TE wave and the TM wave can separate from each other.

Figure 6 is a schematic cross-sectional view illustrating a preferred embodiment of part of fabrication processes of the diffractive optical element in Fig. 2. The hydrogen-containing carbonaceous membrane 6 herein bears a gold mask 7 on its surface. The gold mask 7 is patterned as plural lines. The line-like gold mask 7 is rectangular in a cross section perpendicular to a longitudinal direction and has a considerable thickness. Helium ions 8 are applied to the surface of the hydrogen-containing carbonaceous membrane 6 diagonally from above the gold mask 7. Regions irradiated with the helium ions 8 have a decreased hydrogen content of less than 50 atomic percent and constitute regions 5 having a relatively high refractive index. In contrast, regions not irradiated with the helium ions 8 maintain their hydrogen contents to more than 50 atomic percent and constitute regions 4 having a relatively low refractive index. Thus, the hydrogen-containing carbonaceous membrane 6 in Fig. 6 has regions 5 having a relatively high refractive index and regions 4 having a relatively low refractive index, in which the interfaces between these regions are inclined with respect to the surface of the hydrogen-containing carbonaceous membrane 6.

In the embodiments illustrated in Figs. 2 to 6, the regions having a relatively low refractive index and the regions 5 having a relatively high refractive index are inclined with respect to the perpendicular of the surface of the hydrogen-containing carbonaceous membrane 6. These are only examples, and the regions 4 and the regions 5 may be arranged in parallel with the perpendicular of the surface of the hydrogen-containing carbonaceous membrane 6. The description on the translucent substrate is omitted in Figs. 3 to 6, for the sake of convenience in explanation.

In the hydrogen-containing carbonaceous membranes having a distribution of refractive index, the hydrogen-containing carbonaceous membrane according to the first embodiment and the hydrogen-containing carbonaceous membrane according to the second embodiment may constitute the regions having a relatively low refractive index and the regions having a relatively high refractive index, respectively.

A region having a relatively high electric resistivity and another region having a relatively low electric resistivity may constitute the regions having a hydrogen content of more than 50 atomic percent and the regions having a hydrogen content of less than 50 atomic percent, respectively, in the hydrogen-containing carbonaceous membranes according to the third embodiment of the present invention. Electrically useful elements may be obtained by allowing hydrogen-containing carbonaceous membranes to have a distribution of electric resistivity in a direction in parallel with the surface thereof. Such hydrogen-containing carbonaceous membranes include, for example, a hydrogen-containing carbonaceous membrane comprising the hydrogen-containing carbonaceous membrane according to the first embodiment and the hydrogen-containing carbonaceous membrane according to the second embodiment as the regions having a relatively high electric resistivity and the regions having a relatively low electric resistivity, respectively.

The hydrogen-containing carbonaceous membranes according to the third embodiment of the present invention may be prepared, for example, by applying ions, light, or electron beams to part of the surface of a hydrogen-containing carbonaceous membrane according to the first embodiment, and thus removing hydrogen in applied regions to thereby reduce the hydrogen contents in the applied regions to less than 50 atomic percent.

The distribution of hydrogen content may also be formed in a thickness direction of the hydrogen-containing carbonaceous membrane. This may be achieved, for example, by using decay of applied light, multistep application of ions having different energy, or multistep application of electron beams having different energy. The distribution of hydrogen content may also be formed in a diagonal direction to a thickness direction of a hydrogen-containing carbonaceous membrane by applying, for example, ions, light, or electron beams to a diagonal direction to the surface of the hydrogen-containing carbonaceous membrane. This may yield elements having more chemically, acoustically, electrically, or optically complicated functions.

Hydrogen-containing carbonaceous membranes each having at least two regions having different properties, as in the hydrogen-containing carbonaceous membranes according to the third embodiment of the present invention, can be prepared by applying, for example, ions, light, or electron beams to part of the surface of the hydrogen-containing carbonaceous membranes according to the first embodiment.

### EXAMPLES

### (EXPERIMENTAL EXAMPLE 1)

A series of hydrogen-containing carbonaceous membranes as Sample Numbers. 1 to 8 were prepared on silicon substrate by using any of cathode arc ion plating, sputtering, and RF plasma CVD.

The cathode arc ion plating (Nos. 1 and 2) was carried out by subjecting solid carbon as a raw material to vapor phase synthesis in an argon atmosphere (No. 1) or in an atmosphere of a gaseous mixture of argon and hydrogen (No. 2). The sputtering (Nos. 3 and 4) was carried out by carrying out vapor phase synthesis in a gaseous mixture of argon and methane gas using solid carbon and methane gas as raw materials. The RF plasma CVD (Nos. 5 to 8) was carried out by subjecting propane as a raw material to vapor phase synthesis. In this RF plasma CVD technique, the temperature of the substrate during vapor phase synthesis was 50°C to 150°C. The properties of the resulting hydrogen-containing carbonaceous membranes were varied by, for example, changing the electric power to be applied during vapor phase synthesis.

The prepared hydrogen-containing carbonaceous membranes of Nos. 1 to 8 were determined on hydrogen content, density, stress, spin density, thickness and surface roughness by calculation. The results are shown in Table I. In these procedures, the hydrogen content was determined by calculation according to Rutherford backscattering spectrometry (RBS) and hydrogen forward scattering spectrometry (HFS), and the density was determined by calculation according to an X-ray reflectivity (GIXR) technique. The stress was determined by calculation based on the warpage of the silicon substrate, and the spin density was determined by calculation according to an electron spin resonance (ESR) technique. The surface roughness was determined by extracting an arbitrary portion 1 mm long from the surface roughness curve of a sample hydrogen-containing carbonaceous membrane and calculating the arithmetic mean surface roughness Ra of the extracted portion. The "thickness" in Table I shows the thickness of a sample hydrogen-containing carbonaceous membrane upon the determination of the properties such as hydrogen content. The "remarks" in Table I shows the thickness of the sample hydrogen-containing carbonaceous membrane at the time when the hydrogen-containing carbonaceous membrane delaminated from the substrate, after it had been further grown after the above-mentioned determination.

**[Table I]**

| Sample number | Preparation process | Hydrogen content (atomic percent) | Density (g/cm³) | Stress | | Spin density (spins/cm³) | Thickness (µm) | Surface roughness Ra (µm) | Remarks |
|---|---|---|---|---|---|---|---|---|---|
| | | | | Type | Intensity (GPa) | | | | |
| 1 | Cathode are ion plating | 0 | 3.24 | Compressive | 12 | 2.2x 10²⁰ | 1 | 0.18 | Delaminated at a thickness of 2.5 µm or more |
| 2 | Cathode arc ion plating | 2 | 3.05 | Compressive | 8.8 | 5.8x 10¹⁹ | 1 | 0.17 | Delaminated at a thickness of 2.0 µm or more |
| 3 | Sputtering | 8 | 2.74 | Compressive | 7.9 | 8.2x 10¹⁹ | 1.5 | 0.14 | Delaminated at a thickness of 2.0 µm or more |
| 4 | Sputtering | 22 | 2.08 | Compressive | 4.9 | 5.9x 10¹⁸ | 1.2 | 0.1 | Delaminated at a thickness of 1.5 µm or more |
| 5 | RF plasma CVD | 14 | 2.42 | Compressive | 5.3 | 2.2x 10¹⁸ | 1.2 | 0.08 | Delaminated at a thickness of 1.5 µm or more |
| 6 | RF plasma CVD | 37 | 1.91 | Compressive | 2.8 | 5.2x 10¹⁷ | 1.6 | 0.09 | Delaminated at a thickness of 2.0 µm or more |
| 7 | RF plasma CDV | 54 | 1.40 | Compressive | 0.45 | 3-3x 10¹⁶ | 7.2 | 0.06 | No delamination |
| 8 | RF plasma CVD | 59 | 1.36 | Compressive | 0.09 | Less than 3.0x 10¹⁶ | 6.4 | 0.05 | No delamination |

Table I demonstrates that the hydrogen-containing carbonaceous membranes of Sample Nos. 7 and 8 did not delaminate from the substrates even at a film thickness of 6 µm or more, but the other hydrogen-containing carbonaceous membranes of Sample Nos. 1 to 6 delaminated from the substrates. The hydrogen-containing carbonaceous membranes of Sample Nos. 7 and 8 have hydrogen contents of more than 50 atomic percent and less than 65 atomic percent, and densities of more than 1.3 g/cm³ and less than 1.5 g/cm³.

### (EXPERIMENTAL EXAMPLE 2)

Seven samples including a hydrogen-containing carbonaceous membrane arranged on a quartz substrate were prepared by RF plasma CVD using cyclohexane as a raw material. The hydrogen-containing carbonaceous membranes each had a hydrogen content of 55 atomic percent, a density of 1.38 g/cm³, a compressive stress of 0.21 GPa, a spin density of less than 3x 10¹⁶ spins/cm³, and a thickness of 0.8 to 1.1 µm. Next, hydrogen-containing carbonaceous membranes of Sample Nos. 9 to 15 were prepared by irradiating the above-prepared hydrogen-containing carbonaceous membranes with any of UV laser light, SR light, and helium ions under different conditions. The hydrogen content, density, stress, and spin density were determined on the hydrogen-containing carbonaceous membranes of Sample Nos. 9 to 15. The results are shown in Table II. The uppermost line of the samples in Table II shows the properties of the hydrogen-containing carbonaceous membrane before irradiation with the UV laser light, SR light, or helium ions.

**[Table II]**

| Sample number | Irradiation | Hydrogen content (atomic percent) | Density (g/cm³) | Stress | | Spin density spins/cm³ |
|---|---|---|---|---|---|---|
| | | | | Type | Intensity (GPa) | |
| - | Before irradiation | 55 | 1.38 | Compressive | 0.21 | 3x 10¹⁶ |
| 9 | UV laser light | 48 | 1.44 | Tensile | 0.08 | 1.8x 10¹⁷ |
| 10 | UV laser light | 37 | 1.55 | Tensile | 0.22 | 6.8x 10¹⁷ |
| 11 | UV laser light | 18 | 1.68 | Tensile | 0.65 | 7x 10¹⁸ |
| 12 | SR light | 28 | 1.65 | Tensile | 0.45 | 1.1x 10¹⁸ |
| 13 | SR light | 6 | 1.81 | Tensile | 0.82 | 3.2x 10¹⁹ |
| 14 | Helium ion | 45 | 1.48 | Tensile | 0.15 | 3.2x 10¹⁷ |
| 15 | Helium ion | 25 | 1.68 | Tensile | 0.55 | 1.9x 10¹⁸ |

Table II demonstrates that the hydrogen-containing carbonaceous membranes of Sample Nos. 9 to 15 showed decreased hydrogen contents of less than 50 atomic percent after irradiation with, for example, UV laser light, as compared with those before irradiation. The hydrogen-containing carbonaceous membranes of Sample Nos. 9 to 15 showed higher densities of 1.4 g/cm³ to 1.9 g/cm³ after irradiation than those before irradiation. After the irradiation, the hydrogen-containing carbonaceous membranes of Sample Nos. 9 to 15 each had a tensile stress. In contrast, they had a compressive stress before irradiation. They showed higher spin densities after irradiation, than those before irradiation.

### (EXPERIMENTAL EXAMPLE 3)

A hydrogen-containing carbonaceous membrane was formed on a copper interconnection of a flexible printed board by RF plasma CVD using methane as a raw material. The flexible printed board included a polyimide substrate and the copper interconnection arranged on the substrate. The resulting hydrogen-containing carbonaceous membrane had a thickness of 10 µm, a hydrogen content of 53 atomic percent, and a density of 1.39 g/cm³. The insulating properties of the formed hydrogen-containing carbonaceous membrane were determined to find that the hydrogen-containing carbonaceous membrane functioned as an insulating protective membrane for an uncovered portion of the copper interconnection. The flexible printed board after the formation of the hydrogen-containing carbonaceous membrane was subjected to bending tests one hundred thousand times. As a result, the hydrogen-containing carbonaceous membrane did not delaminate and showed sufficient durability.

### (EXPERIMENTAL EXAMPLE 4)

A hydrogen-containing carbonaceous membrane was formed on a translucent quartz substrate by RF plasma CVD using methane as a raw material. The resulting hydrogen-containing carbonaceous membrane had a thickness of 3 µm, a hydrogen content of 56 atomic percent, and a density of 1.37 g/cm³. A gold (Au) mask patterned as lines was formed on the surface of the hydrogen-containing carbonaceous membrane, and SR light was applied to the hydrogen-containing carbonaceous membrane from above. Thus, hydrogen contents in irradiated portions were reduced to less than 50 atomic percent. The gold mask was then removed to yield a hydrogen-containing carbonaceous membrane. This had regions having a relatively high relatively refractive index (regions having a hydrogen content of less than 50 atomic percent), and regions having a relatively low refractive index (regions having a hydrogen content of more than 50 atomic percent). The former regions and the latter regions were arranged in alternate order in parallel with the surface of the hydrogen-containing carbonaceous membrane. The hydrogen-containing carbonaceous membrane was irradiated with light to find that it functioned as a refractive index-modulated diffractive optical element.

### (EXPERIMENTAL EXAMPLE 5)

A hydrogen-containing carbonaceous membrane was formed on a translucent quartz substrate having a refractive index of 1.46. The resulting hydrogen-containing carbonaceous membrane has a thickness of 8.5 µm, a refractive index of 1.52, a hydrogen content of 53 atomic percent, and a density of 1.37 g/cm³. The surface of the hydrogen-containing carbonaceous membrane was irradiated with SR light. After irradiation with SR light, the outermost surface of the hydrogen-containing carbonaceous membrane had a hydrogen content of 19 atomic percent, a density of 1.67 g/cm³, and the other side of the hydrogen-containing carbonaceous membrane facing the quartz substrate had a hydrogen content of 48 atomic percent and a density of 1.41 g/cm³. The hydrogen-containing carbonaceous membrane had a refractive index of 2.15 on its side irradiated with SR light, and had a refractive index of 1.55 on the other side facing the substrate. Specifically, the hydrogen-containing carbonaceous membrane had a distribution of refractive index in a thickness direction. The hydrogen contents herein were determined by calculation according to Rutherford backscattering spectrometry (RBS) and hydrogen forward scattering spectrometry (HFS), and the densities were determined by calculation according to an X-ray reflectivity (GIXR) technique. The measurements on the outermost surface were determined from the surface of the hydrogen-containing carbonaceous membrane. The measurements on the other side of the hydrogen-containing carbonaceous membrane facing the substrate were determined after subjecting the hydrogen-containing carbonaceous membrane to ion etching from the surface side so that the etched membrane had a thickness of 0.5 µm from the substrate. The refractive indexes were determined according to spectroscopic ellipsometry. Next, a translucent substrate was arranged on the side of the hydrogen-containing carbonaceous membrane irradiated with SR light. This substrate contained zinc sulfide and had a refractive index of 2.20. Thus, a diffractive optical element was prepared. The diffractive optical element had a gradual distribution of refractive index ranging from the quartz substrate to the zinc sulfide substrate. The diffractive optical element showed high optical transmittance in entire regions ranging from the quartz substrate to the zinc sulfide substrate. This is because the diffractive optical element had significantly decreased optical reflection loss at the interfaces between the quartz substrate and the hydrogen-containing carbonaceous membrane and between the zinc sulfide substrate and the hydrogen-containing carbonaceous membrane.

It should be noted that the above disclosed embodiments and experimental examples are entirely illustrative and not restrictive. It should also be understood that the scope of the present invention is defined by the appended claims rather than by the description preceding them, and all changes and modifications that fall within meets and bounds of the claims, or equivalence of such meets and bounds are therefore intended to embraced by the claims.

### Industrial Applicability

Hydrogen-containing carbonaceous membranes having novel properties are obtained by specifying the hydrogen contents and densities thereof within specific ranges. For example, the resulting hydrogen-containing carbonaceous membranes may be effectively prevented from delamination from substrates.

## Claims

1. A hydrogen-containing carbonaceous membrane comprising carbon and hydrogen, wherein the hydrogen-containing carbonaceous membrane has a hydrogen content of more than 50 atomic percent and less than 65 atomic percent, and wherein the hydrogen-containing carbonaceous membrane has a density of more than 1.3 grams per cubic centimeter (g/cm³) and less than 1.5 g/cm³.

2. The hydrogen-containing carbonaceous membrane according to Claim 1, wherein the hydrogen-containing carbonaceous membrane has a compressive stress.

3. The hydrogen-containing carbonaceous membrane according to Claim 2, wherein the compressive stress is more than 0.01 gigapascal (GPa) and less than 1 GPa.

4. The hydrogen-containing carbonaceous membrane according to any one of Claims 1 to 3, wherein the hydrogen-containing carbonaceous membrane has a spin density of less than 5x 10¹⁶ spins per cubic centimeter (spins/cm³).

5. A hydrogen-containing carbonaceous membrane comprising carbon and hydrogen, wherein the hydrogen-containing carbonaceous membrane has a hydrogen content of more than 0 atomic percent and less than 50 atomic percent, and wherein the hydrogen-containing carbonaceous membrane has a density of more than 1.4 g/cm³ and less than 1.9 g/cm³.

6. The hydrogen-containing carbonaceous membrane according to Claim 5, wherein the hydrogen-containing carbonaceous membrane has a tensile stress.

7. The hydrogen-containing carbonaceous membrane according to Claim 6, wherein the tensile stress is more than 0.05 GPa and less than 1 GPa.

8. The hydrogen-containing carbonaceous membrane according to any one of Claims 5 to 7, wherein the hydrogen-containing carbonaceous membrane has a spin density of more than 1x 10¹⁷ spins/cm³ and less than 1x 10²⁰ spins/cm³.

9. A hydrogen-containing carbonaceous membrane comprising carbon and hydrogen, wherein the hydrogen-containing carbonaceous membrane includes at least one region and another region, the region having a hydrogen content of more than 50 atomic percent, and the other region having a hydrogen content of less than 50 atomic percent.

10. The hydrogen-containing carbonaceous membrane according to Claim 9, wherein the region having a hydrogen content of more than 50 atomic percent comprises the hydrogen-containing carbonaceous membrane according to any one of Claims 1 to 4, and wherein the region having a hydrogen content of less than 50 atomic percent comprises the hydrogen-containing carbonaceous membrane according to any one of Claims 5 to 8.

11. The hydrogen-containing carbonaceous membrane according to one of Claims 9 and 10, wherein the region having a hydrogen content of more than 50 atomic percent comprises a region having a relatively low refractive index, and wherein the region having a hydrogen content of less than 50 atomic percent comprises a region having a relatively high refractive index.

12. The hydrogen-containing carbonaceous membrane according to any one of Claims 9 to 11, wherein the region having a hydrogen content of more than 50 atomic percent comprises a region having a relatively high electric resistivity, and wherein the region having a hydrogen content of less than 50 atomic percent comprises a region having a relatively low electric resistivity.

13. The hydrogen-containing carbonaceous membrane according to any one of Claims 5 to 12, wherein the hydrogen-containing carbonaceous membrane has a distribution of hydrogen content in a thickness direction.
